(19) **Europäisches Patentamt**

**European Patent Office**

**Office européen des brevets**

(11) **EP 1 662 660 A2**

(12) **EUROPEAN PATENT APPLICATION**

(43) Date of publication:
**31.05.2006 Bulletin 2006/22**

(51) Int Cl.:
***H03K 19/003*** (2006.01)

(21) Application number: **05025953.0**

(22) Date of filing: **29.11.2005**

(84) Designated Contracting States:
**AT BE BG CH CY CZ DE DK EE ES FI FR GB GR HU IE IS IT LI LT LU LV MC NL PL PT RO SE SI SK TR**
Designated Extension States:
**AL BA HR MK YU**

(30) Priority: **29.11.2004 IN DE23842004**

(71) Applicant: **STMicroelectronics Pvt. Ltd**
**Noida-201 301, Uttar Pradesh (IN)**

(72) Inventors:
• **Gupta, Sushil Kumar**
**Noida-201301, UP (IN)**
• **Garg, Paras**
**Noida, UP (IN)**

(74) Representative: **Ferrari, Barbara**
**Botti & Ferrari S.r.l.,**
**Via Locatelli, 5**
**20124 Milano (IT)**

(54) **Method and apparatus for providing compensation against temperature, process and supply voltage variation**

(57) In the present invention an apparatus and method for providing compensation against temperature, process and supply voltage variation in MOS circuits has been proposed. The invention provides a change in process, temperature and voltage detection circuit, which controls the body bias and the drive of the devices in the CMOS circuit. The detection circuit is independent of any input or internal signal of the CMOS circuit to be controlled.

**Figure 4**

**Description**

Field of the Invention

The present invention relates to a method and apparatus for providing compensation against temperature, process and supply voltage variation.

Background of the Invention

When a signal is transmitted in long distance through copper traces or transmission lines, noise is introduced in the signal. Thus, a receiver at a receiving end of such transmission lines does not see a perfect square wave.
The transmitted signal gets worst when the ground and supply references bounce (because of pin package inductance, for instance) thus making logic high and low levels equal to damped sinusoidal signals. In such cases, a Schmitt trigger circuit is frequently used at the receiver end to filter the noise.
As it is well known, a Schmitt trigger is an electronic circuit used to turn a signal having slow or asymmetrical transition into a signal with a sharp transition region. Such a Schmitt trigger circuit cleans up the input signal from noise and provides very sharp transitions.
However, Schmitt trigger circuits are slower and consume more power compared to similar non-Schmitt circuits. Moreover, the Schmitt circuit characteristic is very much dependent on process and temperature variations because process and temperature directly affects the threshold voltages, which is not under control.
Once a chip of integrated circuits is fabricated, the manufacturing process is fixed but the operating temperature and voltage change the low and high level transition points and hence the hysteresis of the used Schmitt circuit.
For very slow transitions and long distance transmissions, a Schmitt trigger circuit with large value of hysteresis is thus required.

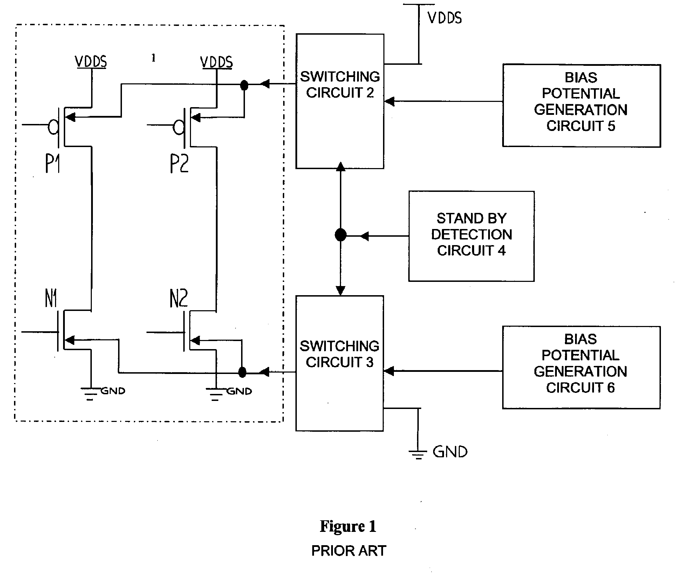

Figure 1 diagrammatically shows a semiconductor integrated circuit incorporated with substrate bias control circuit, realised according to the prior art and described in the USPN 5461338. Bias potential generation circuits 5 and 6 generate bias voltage only if the circuit is in normal mode (not in standby mode).
These bias generation circuits 5 and 6 generate two separate signals for the well of PMOS transistors and the substrate of NMOS transistors which forward biases the body-source of the CMOS configurations. It helps in reduction of the threshold voltages of the CMOS configurations and hence better speed is achieved.
According to the above referred patent, bias potential must be smaller than the flat band voltage between semiconductor substrate and source junction of the transistors. This bias potential is not generated in standby mode to reduce power.
Moreover, switching circuits 2 and 3 have been introduced between the body and the source junctions of the transistors to take care of the standby signal. A separate standby detection circuit 4 generates the standby signal.
The proposed architecture saves power in standby mode and achieves significant improvement in the operational speed especially when a high voltage device is operated at low voltages. However, the proposed integrated circuit does not take care of the process, temperature or supply voltage variations. So it is very sensitive to the process and environmental conditions and tt may lead to more power consumption if bias voltage becomes greater than the flat-band voltage.

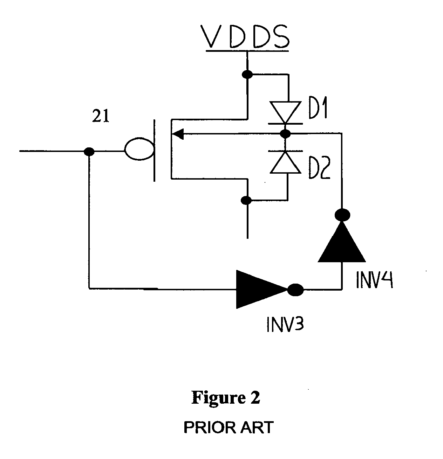

Figure 2 diagrammatically shows another prior art control device aimed to enhance the operational speed even at very low supply voltages, as described in USPN 6515534. The illustrated diodes D1 and D2 are the parasitic diodes formed between body and source/drain junction of a PMOS transistor 21. INV3 and INV4 are two CMOS inverters, which detect a gate signal of the PMOS transistor 21 and generate a bias signal for the body of the PMOS transistor 21.
Whenever the gate signal goes low to turn PMOS transistor 21 ON, the body (well) of the PMOS transistor 21 also goes low and diodes D 1 and D2 are forward biased. This reduces the threshold voltage of the PMOS transistor 21 and provides more drain current through diodes D1 and D2, which increase the operational speed of the PMOS transistor 21.
The described circuit detects the signal from the gate of the MOS transistor or device and biases the body accordingly so that the device operates in a faster manner.
Since a large amount of current flows through the diodes D1 and D2, if the MOS transistor size is large (as it is in case of IOs), latchup can be a problem. This known circuit also does not take care of the changes in process and environmental conditions.
As already described, also known in the field of the invention are Schmitt trigger circuits.

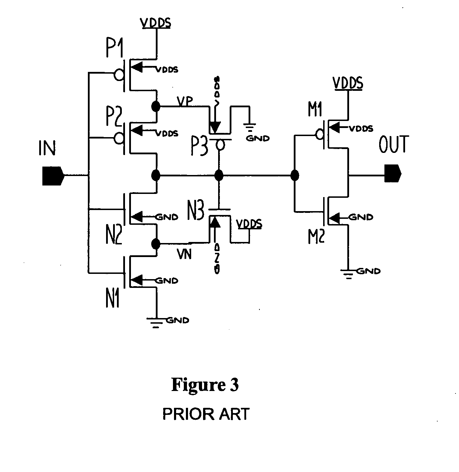

Figure 3 schematically shows a widely used conventional Schmitt trigger circuit. Such a circuit comprises four stacked parallel input MOSFET transistors P1, P2, N1 and N2 which are coupled by their respective gate electrodes to a trigger input terminal IN of the trigger circuit.
Depending on the transition of a signal applied to the trigger input terminal IN, VP or VN signals are generated by the input transistors, such signals being controlled by the transistor size ratios P3/P1 and N3/N1. Further MOS transistors M1 and M2 make an output inverter to provide a sharp transition at an output terminal OUT of the trigger circuit.

The known Schmitt trigger circuit also comprises further MOS transistors, P3 and N3, which realise a feedback structure to control the input PMOS and NMOS transistors.

In particular, if the signal at the trigger input terminal IN is low then the transistor P3 is OFF and the transistor N3 is ON and thus the signal at the output terminal OUT goes low. As the signal at the trigger input terminal IN increases, the transistor NMOS N1 begins to turn ON and the signal VN starts to fall down.

A first or low-to-high trip point (Vih) of this Schmitt trigger circuit is defined when the signal at the trigger input terminal IN is equal to Vtn2+VN, therein Vtn2 is the threshold voltage of the NMOS transistor N2, such a condition corresponding to when the NMOS transistor N2 turns ON.

In fact, when the transistor N2 turns ON, the voltage at its drain starts falling down and turns the transistor NMOS N3 OFF. Once the transistor N2 is ON, the transition is thus very fast.

If the N2 transistor size is large when compared to the sizes of the transistors N1 and N3, then the low-to-high trip point (Vih) is accurately decided by the ratio of N3/N1. Similarly, a high-to-low trip point (Vil) is decided by the ratio of P3/P1.

This known circuit is sensitive to the positive supply voltage VDDS as well as to the process because the threshold voltage Vth of the transistors P3 and N3 keeps on changing as the node VP or VN goes up or comes down respectively with the signal at the trigger input terminal IN. In summary, at low supply voltage this known circuit does not work properly.

All the known circuits including Schmitt trigger as discussed above are sensitive or more sensitive to process, temperature and voltage variations. In a noisy environment, a very stable circuit is required which should be independent of process and environmental conditions for optimum performance. In such a case a process and environmental adaptive circuit is required which will stabilize a signal at an output terminal.

Furthermore, most of the prior art circuits provide large values of hysteresis at high operation voltages, but are not efficient at low voltage (1.8V or 2.5V) because of threshold voltage variation.

Summary of the Invention

To obviate the above drawbacks it is an object of the present invention to provide a method for providing compensation against temperature, process and supply voltage variation as claimed in claim 1.

Another object of the invention is to an apparatus for providing compensation against temperature, process and supply voltage variation as claimed in claims 6 for a MOS circuit and in claim 9 for a CMOS circuit.

Yet another object of the invention is a compensated circuit against temperature, process and supply voltage variation as claimed in claim 15.

The present invention provides structures and methods for a very stable MOS circuit. The high and low threshold levels of the proposed circuit are very less sensitive to process, temperature and voltage, which provides stable hysteresis. Different implementations of the method have been presented for low power, high speed and minimum area.

Brief Description of the Drawings

Figure 1 schematically shows an integrated circuit realised according to the prior art.

Figure 2 schematically shows a control device realised according to the prior art.

Figure 3 schematically shows a widely used Schmitt trigger circuit realised according to the prior art.

Figure 4 schematically shows a block diagram for the threshold voltage control and drive control according to the change in process, voltage and temperature in accordance with the method of the present invention.

Figure 5 shows a control circuit according to a first embodiment of the present invention.

Figures 6-9 are schematic diagrams for generation of NWELL signal according to the present invention.

Figures 10-13 are schematic diagrams for generation of bulk control signal according to the present invention.

Figure 14 shows a control circuit according to a second embodiment of the present invention.

Figures 15-18 are schematic diagrams for generation of drive control signal according to the present invention.

Figures 19 and 20 show waveforms of internal signals of the control circuit according to the present invention.

Figure 21-28 show the simulation results of the circuit realised according to the present invention in comparison with a control circuit realised according to the prior art.

Detailed Description of the Invention

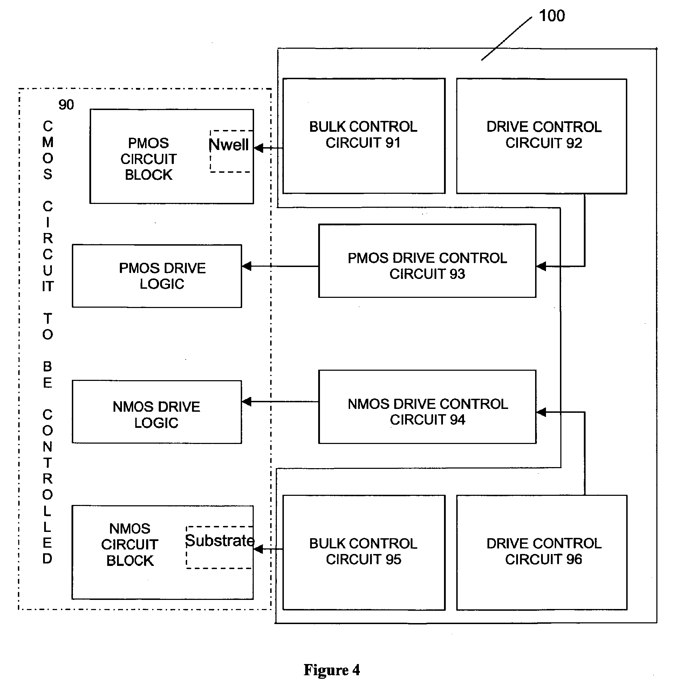

The method for providing compensation against temperature, process and supply voltage variation according to the present invention can be used to control any type of CMOS circuits. A block diagram showing the principles of the proposed method is shown in Figure 4.

In particular, Figure 4 shows in a block diagram the detection of the change in process, temperature and supply voltage (also referred to as PVT - process, voltage, temperature variation) and its application in controlling a device characteristic and behavior, the device being generally indicated by 90.

As it will be clear from the following description, the effect of change in threshold voltage and the suitable driving of the devices due to PVT variations are reduced through a PVT detection circuit, generally indicated by 100. In particular, such a PVT detection circuit 100 includes bulk control circuits 91 & 95 and drive control circuits 92 & 96 to generate control signals for the substrates of the PMOS and NMOS transistors included in the device to be controlled and for driving respective PMOS and NMOS drive control circuits 93 & 94.

More particularly, the drive control circuits 92 & 96 are connected to the respective PMOS and NMOS drive control circuits, 93 and 94, which control the drive level of the MOS transistors included in the device to be controlled, in particular a CMOS device including PMOS and NMOS transistors.

The bulk control circuit 91 is connected to a Nwell portion of a PMOS circuit block of the device 90 and the bulk control circuit 95 is connected to a substrate portion of a NMOS circuit block of the device 90, while the PMOS drive control circuit 93 is connected to a PMOS drive logic of the device 90 and the NMOS drive control circuit 94 is connected to a NMOS drive logic of the device 90. Moreover, the drive control circuit 92 is connected to the PMOS drive control circuit 93 and the drive control circuit 96 is connected to the NMOS drive control circuit 94.

The proposed PVT detection circuit 100 does not take any input or control signal from the device internal elements and it is completely independent of the modes of operation of the devices to be controlled. Moreover, the PVT detection circuit 100 can be different for the body-bias control or the drive control, being thus flexible for different possibility of implementation.

In particular, the PVT detection circuit 100 separately generates four control signals namely control signals for Nwell (body of the PMOS transistors), substrate (body of the NMOS transistors) and two other signals for the PMOS and NMOS drive control circuits 93 & 94, which can be implemented in several ways. These control signals assist in controlling the bulk voltage and drive level in a MOS circuit. Accordingly a stable threshold voltage is maintained in the transistors included in the device 90 to be controlled by providing compensation against temperature, process and supply voltage variation.

More generally, the method for providing compensation against temperature, process and supply voltage variation in a device comprising MOS transistors according to the present invention advantageously comprises the steps of:

-   sensing the process, temperature or supply voltage variation;

-   controlling a bulk bias voltage of the MOS transistors to maintain a constant threshold voltage; and

-   controlling a drive level of the MOS transistors to compensate for the effects of the process, temperature or supply voltage variation.

Advantageously, the step of controlling the bulk bias voltage is achieved by increasing a bulk voltage with respect to an input diode below said input diode cut in voltage, as will be further explained in the following description.

Moreover, the step of controlling the drive level is achieved by switching in additional drive transistors connected to the MOS transistors to increase or decrease a drive current of the MOS transistors themselves.

Also advantageously according to the present invention, the step of controlling of the bulk bias voltage is done separately for N type semiconductor substrate and P type semiconductor substrate of the MOS transistors comprised in the device to be controlled.

In a similar manner, the step of controlling the drive level includes a step of generating separate drive control signals for PMOS and NMOS transistors.

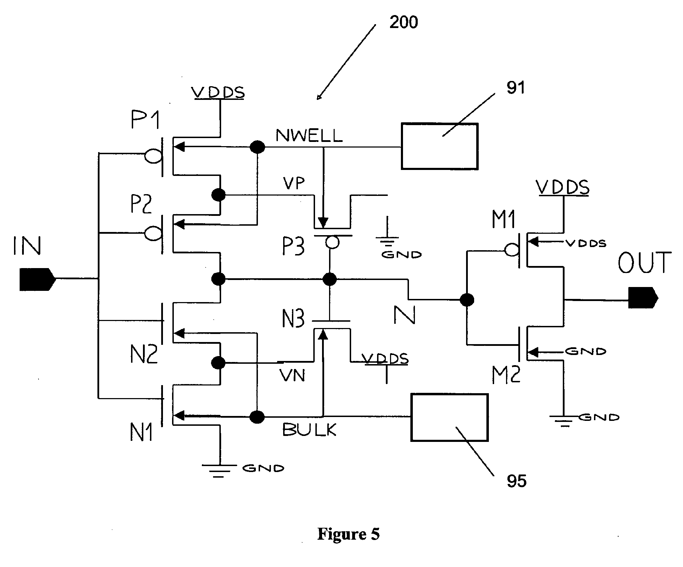

The method for providing compensation against temperature, process and supply voltage variation as above described can be implemented by a new process insensitive, stable Schmitt trigger circuit, which will be presented below as a first embodiment of a compensated circuit according to the present invention, schematically shown in Figure 5. However the invention is not limited to the same and extends to MOS circuits. In particular, according to the invention a stable MOS circuit, which is stable against PVT variations is obtained.

Figure 5 shows a first embodiment of the compensated circuit according to the present invention, globally indicated by 200.

The compensated circuit 200 according to the present invention has a basic structure similar to the trigger circuits already described with reference to the prior art solutions. In particular the compensated circuit 200 comprises four input transistors P1, P2, N1 and N2 of the MOS type, in series to each other and connected between a first and a second voltage references, in particular a power supply voltage reference VDDS and a ground GND. The input transistors P1, P2, N1 and N2 are coupled by their respective gate electrodes to an input terminal IN of the compensated circuit 200. More particularly, the first and second input transistors P1 and P2 are PMOS transistors while the third and fourth input transistors N1 and N2 are NMOS transistors.

The compensated circuit 200 also comprises further first and second control transistors, P3 and N3, of the MOS type, which realise a feedback structure to control the input PMOS and NMOS transistors. In particular, the first control transistor P3 is a PMOS transistor inserted between an interconnection node between the first and second input transistors P1 and P2 and the ground GND and has a gate terminal connected to the gate terminal of the second control transistor N3, which is in turn a NMOS transistor inserted between an interconnection node between the third and fourth input transistors N1 and N2 and the power supply voltage reference VDDS.

Depending on the transition of a signal applied to the input terminal IN, VP or VN signals are generated at the interconnection nodes between the input transistors P1 and P2, respectively N1 and N2, such signals being controlled by the transistor size ratios P3/P1 and N3/N1.

Finally output transistors M 1 and M2 of the MOS type make an output inverter connected to an output terminal OUT of the compensated circuit 200. The output transistors M1 and M2 are inserted, in series to each other, between the power supply voltage reference VDDS and ground GND and have respective gate terminals connected to each other and to the common gate terminals of the control transistors P3 and N3, also indicated as node N.

In particular, the first output transistor M 1 is of the PMOS type and has a bulk terminal connected to the power supply voltage VDDS and the second output transistor M2 is of the NMOS type and has a bulk terminal connected to ground GND.

Advantageously according to the invention, the first and second input transistors P1 and P2 as well as the first control transistor P3 of the compensated circuit 200, i.e. the transistors of the PMOS type, have bulk terminals connected together and to a first bulk control circuit 91 and receiving a NWELL signal.

In a similar manner, the third and fourth input transistors N 1 and N2 as well as the second control transistor N3 of the compensated circuit 200, i.e. the transistors of the NMOS type, have bulk terminals connected together and to a second bulk control circuit 95 and receiving a BULK signal.

In this way, the threshold voltage of the NMOS and PMOS is controlled by the first and second bulk control circuits 91 & 95, according to the process variation of the circuit 200 itself. It should be noted that the bulk terminals of the NMOS transistors N1, N2, & N3 correspond to a substrate node, which is of P-type in a CMOS process while the bulk or nwell terminals of the PMOS transistors P1, P2 & P3 correspond to a substrate node, which is of N-type in a CMOS process.

Advantageously according to the invention, the high to low transition point Vil is determined by the ratio P 1 / P3 along with the NWELL signal. Similarly, the low to high transition point Vih is determined by the ratio N1/N3 along with BULK signal.

Advantageously according to the invention, the NWELL and BULK signals can be generated by the bulk control circuits 91 and 95, respectively, such circuit being able to detect process variation.

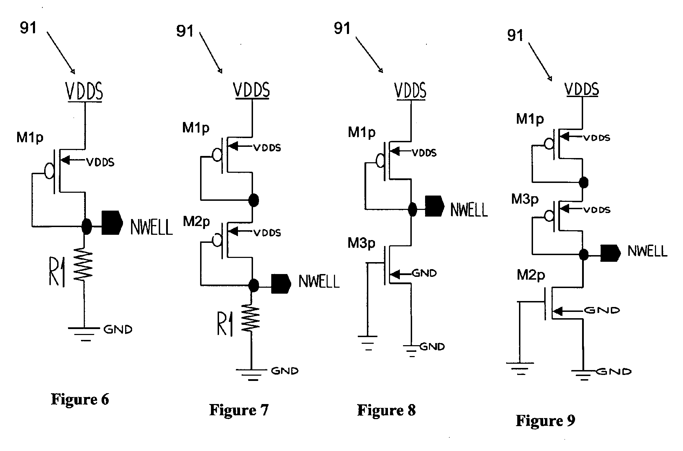

Different embodiments of the bulk control circuit 91 according to the invention are shown in figures 6-9.

In particular, Figure 6 schematically shows a bulk control circuit 91 comprising a PMOS transistor M1p having same channel length as transistors P1 or P2 or P3. The transistor M1p is connected in diode configuration between the power supply voltage reference VDDS and a first control terminal providing the NWELL signal. Moreover, the bulk control circuit 91 comprises a resistor R1' inserted between the first control terminal and ground GND, in series with the transistor M1p. The resistor R1 is required to set the bias current through the transistor M1p. The transistor M1p has a bulk terminal connected to the power supply voltage reference VDDS.

In the steady state, the signal NWELL is at VDDS-|VtM 1|, supposing that the current through the transistor M1p is very low. This NWELL signal is also provided to the NWELL terminals of the PMOS transistors P1, P2 and P3, as shown in figure 5.

The PMOS transistors P1, P2 and P3 have source-nwell and drain-nwell junction that form diodes. If the NWELL signal is below (VDDS- |VtP1|), the diode formed by the source of the first input transistor P1 and its nwell is forward biased and the current flows through the resistor R1 thus causing a DC consumption. If the resistance value of the resistor R 1 is very high, such a current can be reduced.

To avoid this DC consumption, a grounded gate NMOS transistor M2p can be connected in place of the resistor R1, as shown in figure 8. The grounded gate NMOS transistor M2p has a bulk terminal and a gate terminal connected to the ground GND. In this case, the leakage current of the NMOS transistor M2p provides a ground path. The size of the NMOS transistor M2p should be kept large so that the leakage of the NMOS transistor M2p would be larger than the leakage of the NMOS transistor M1p in the OFF state. The NWELL signal is thus quickly pulled down to VDDS- |VtM1p|.

However if the biasing current is not large enough, the performance of the compensated circuit 200 would be dependent on the frequency of the input signal applied to the input terminal IN.

Moreover, it is clear that the NWELL signal is dependent on the threshold voltage of the PMOS M1p that is again dependent on temperature and process. If process gets slow during fabrication, absolute threshold voltages of the PMOS transistors P1, P2 and P3 increases and change the value of transaction point voltage Vil. To keep the transaction point voltage Vil intact, threshold voltages of these PMOS transistors should be decreased. Since an increased value |VtM1p| decreases the NWELL signal value which is connected to the NWELL of the PMOS transistors P1, P2 and P3, the bulk to source voltage |Vsb| decreases. Further this decreases the threshold voltages of the PMOS transistors P1, P2 and P3 against process variation and hence try to neutralize the effect of the process variation.

It should be reminded that a threshold voltage equation of a MOSFET is as follows:

$$Vth=Vth0+Y(SQRT(|2*PHI+Vsb|)-SQRT(|2*PHI|))$$

which includes the body effect. Vth0 is the threshold voltage when Vsb is zero that is body effect is not present.

To further increase the insensitivity of the transaction point with respect to process variation, two series PMOS transistors M1p and M3p can be used, as shown in figures 7 and 9.

In these embodiments of the bulk control circuit 91, a small change dVth will result in 2*dVth change in the NWELL signal, thanks to the series of the transistors M1p and M3p, thus enhancing the control of the PMOS transistors P1-P3 of the compensated circuit 200.

However, since the relationship between Vsb and Vth is not linear, complete neutralization cannot be achieved.

If a bulk control circuit 91 according to the embodiment of figure 9 is used to generate the NWELL signal, the stability of the transaction point Vil increases.

The effect of temperature and voltage is similar to the one correlated to the process. If the temperature increases, the threshold voltage of the PMOS transistors M1p and M3p would fall, which would increase the NWELL signal value and hence the threshold voltage of the PMOS transistors P1, P2 and P3 would increase to counterbalance the effect of increased temperature.

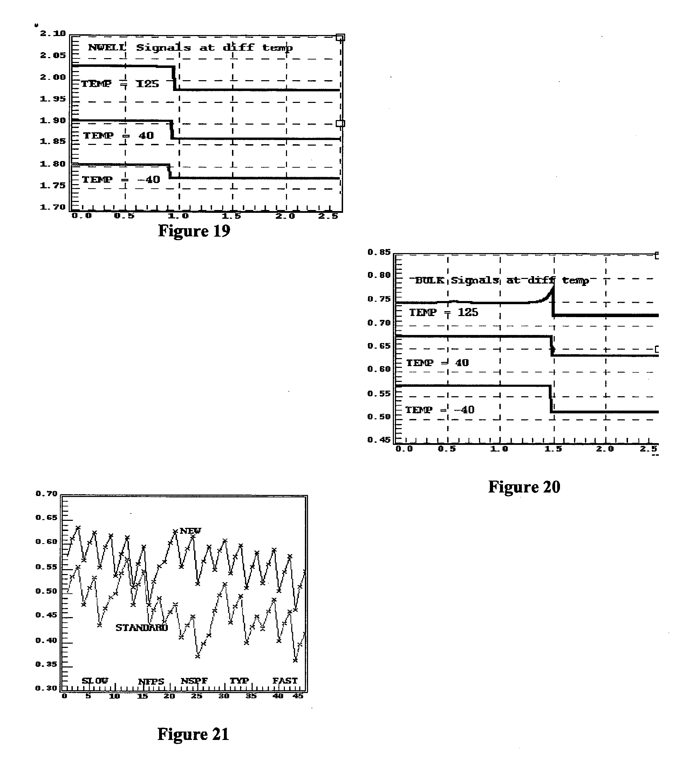

As the signal at the input terminal IN falls, the NWELL signal also changes as shown in the figure 19.

It is clear that as temperature increases, the NWELL signal increases to increase the threshold voltage value Vth of the PMOS transistors P1, P2 and P3.

When the signal at the output terminal OUT makes a transition, the NWELL signal also makes a transition and settles at some value to stop DC current through the parasitic diodes of the PMOS transistors P1-P3.

Referring to figure 19, it is clear that the NWELL signal is low when the signal at the input terminal IN is high, since the PMOS transistor P3 is ON and the channel-nwell junction also forms a diode increasing leakage current through the bulk terminals.

Once the transition is complete, the signal at the input terminal IN is low and the signal at the node N is high, which turns the PMOS transistor P3 OFF. This reduces the number of parallel paths for current through nwell and hence the NWELL signal rises.

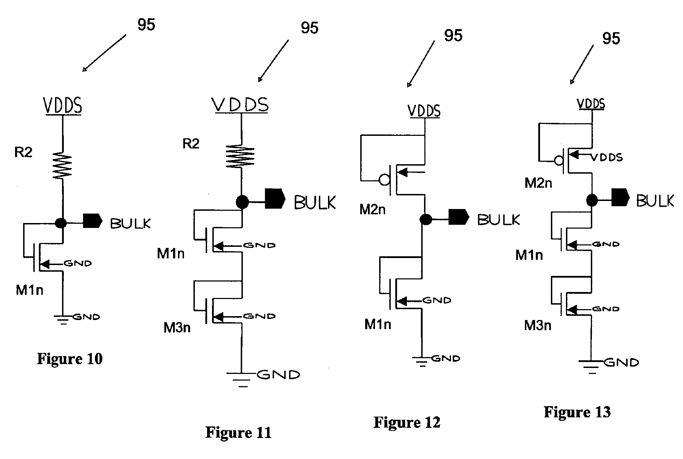

Different embodiments of the bulk control circuit 95 according to the invention are shown in figures 10 to 13. These circuits generate the BULK signal for the control of the NMOS transistors N1, N2 and N3.

In particular, Figure 10 schematically shows a bulk control circuit 91 comprising a NMOS transistor M1n which is connected in diode configuration between the a second control terminal providing the BULK signal and ground GND. Moreover, the bulk control circuit 95 comprises a resistor R2 inserted between the power supply voltage reference VDDS and the second control terminal, in series with the transistor M1n. The transistor M1n has a bulk terminal connected to ground GND.

As previously seen in connection with the bulk control circuit 91 shown in figures 6-9, to avoid DC consumption, a PMOS transistor M2n having a gate terminal connected to the power supply voltage reference VDDS can be connected in place of the resistor R2, as shown in figure 12.

To further increase the insensitivity of the transaction point with respect to process variation, two series NMOS transistors M1n and M3n can be used, as shown in figures 11 and 13.

According to the proposed embodiments of the bulk control circuit 95, the low to high transaction point Vih is determined by the ratio N1/N3 and by the BULK signal. Similar to the control of the NWELL signal, a control of the BULK signal is thus obtained. From the figures it is clear that when threshold voltage of the NMOS transistor M1n increases, either because of process or temperature variation, the BULK signal (which is proportional to the VtMln and VtM2n) increases and the threshold voltages of the NMOS transistors N1, N2 and N3 of the compensated circuit 200 decreases to stabilize the transaction point Vih.

Moreover, a better control of the BULK signal is achieved by the embodiments of figures 11 and 13.

As the signal at the input terminal IN rises, the BULK signal changes because of turn ON/OFF of the NMOS transistor N3 as shown in figure 20.

In summary, the compensated circuit 200 according to the invention, comprising a threshold control, detects the change in process, temperature and voltage and controls the BULK and NWELL signals of the NMOS and PMOS transistors to neutralize the effect of the variation and therefore provides a very stable compensated circuit 200.

In short, the invention provides a self-adjusting circuit for bulk control in MOS devices against the PVT (process, voltage and temperature) variation. When the process is slow, absolute threshold voltage values of all the transistors comprised in the circuit increases and the high to low transaction point Vil shifts towards ground (GND) while the low to high transaction point Vih shifts towards supply (VDDS).

It should be noted that the compensated circuit according to the invention increases the hysteresis, but decreases the noise margin. In fact, for any standard, minimum value of the high to low transaction point Vil is fixed and maximum value of the low to high transaction point Vih is also fixed to take care of low and high logic level noise margins (For TTL level Vil (min)=0.8 Volt and Vih (max)=2.0 Volt according to the designer specifications).

To meet the standards, the compensated circuit 200 according to the invention is set to these values in the worst possible case. For example the high to low transaction point Vil is minimum when all the PMOS transistors are slow and all the NMOS transistors are fast while voltage and temperature is minimum, the low to high transaction point Vih is maximum when all the NMOS transistors are slow and all the PMOS transistors are fast while voltage and temperature are maximum.

In such a case, hysteresis obtained is very low. At low supply voltages the required hysteresis is not easily achieved or very low with the conventional circuits.

Since the threshold voltage of the NMOS and PMOS transistors play major role at the device level in determining the high to low transaction point Vil and the low to high transaction point Vih, it is easy to stabilize the hysteresis if the threshold voltages of the MOS transistors can be controlled according to the PVT variation.

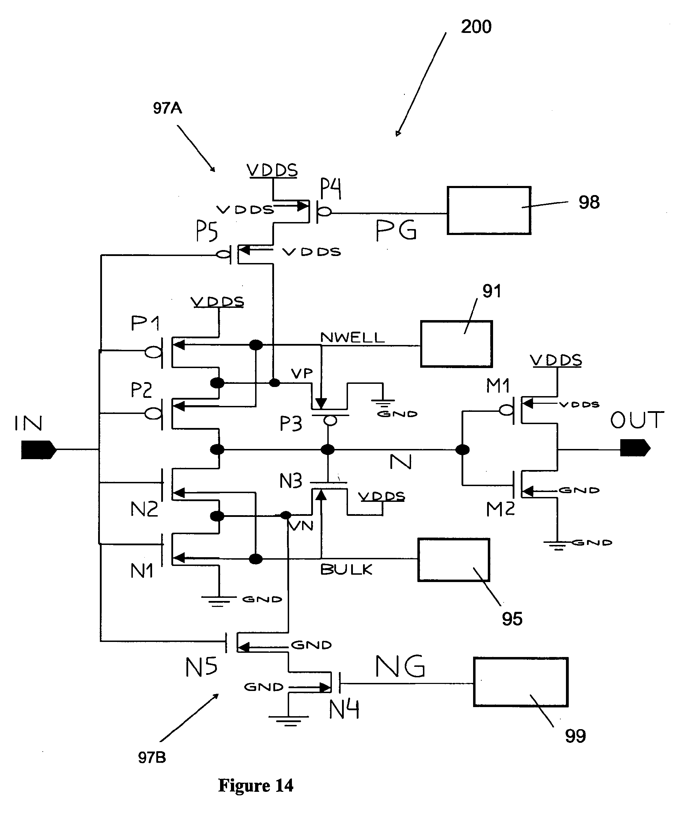

Figure 14 shows a second embodiment of the compensated circuit 200 according to the invention, which employs bias blocks 97A and 97B, suitably connected to respective additional PVT detection circuits 98 and 99 to control the current drive while maintaining the threshold voltage. As will be clear from the following description, the additional PVT detection circuits 98 and 99 are drive control circuits.

According to this embodiment, as the process gets slow the drive of the compensated circuit reduces. Further increment in temperature also makes the circuit slow because of mobility degradation. Increment in supply voltages increases the current and changes the transaction point.

Advantageously according to the invention, all these effects are controlled through the additional PVT detection circuits 98, 99, as shown in the figure.

In particular, the first bias block 97A comprises a series of a first P4 and a second PMOS bias transistor P5 which are added in parallel with the first input PMOS transistor P1 to increase or decrease the current according to the PVT variation. The bias PMOS transistors P4 and P5 are connected, in series to each other, between the power supply voltage reference VDDS and the interconnection node between the first and second input PMOS transistors P1 and P2 and have respective bulk terminals also connected to the power supply voltage reference VDDS. In particular, the second bias PMOS transistor P5 has a gate terminal connected to the input terminal IN of the compensated circuit 200, while the first bias PMOS transistor P4 has a gate terminal connected to the first additional PVT detection circuit 98 and receive a first control signal PG therefrom.

In a similar manner, the second bias block 97B comprises a series of a first N4 and a second NMOS bias transistor N5 which are added in parallel with the first input NMOS transistor N 1 to increase or decrease the current according to the PVT variation. The bias NMOS transistors N4 and N5 are connected, in series to each other, between the interconnection node between the first and second input NMOS transistors N1 and N2 and ground GND have respective bulk terminals also connected to the ground GND. In particular, the second bias NMOS transistor N5 has a gate terminal connected to the input terminal IN of the compensated circuit 200, while the first bias NMOS transistor N4 has a gate terminal connected to the second additional PVT detection circuit 99 and receive a second control signal NG therefrom.

As previously see for the first embodiment of the compensated circuit according to the invention, it further comprises MOS transistors M1 and M2 to form an output inverter to provide sharp transition at the output terminal OUT.

Moreover, the bulk terminals of the NMOS transistors N1, N2 and N3 are connected to the bulk control circuit 91 and receive the signal BULK therefrom - as described earlier - while the bulk terminals of the PMOS transistors P1, P2 and P3 are connected to the bulk control circuit 95 and receive the signal NWELL therefrom.

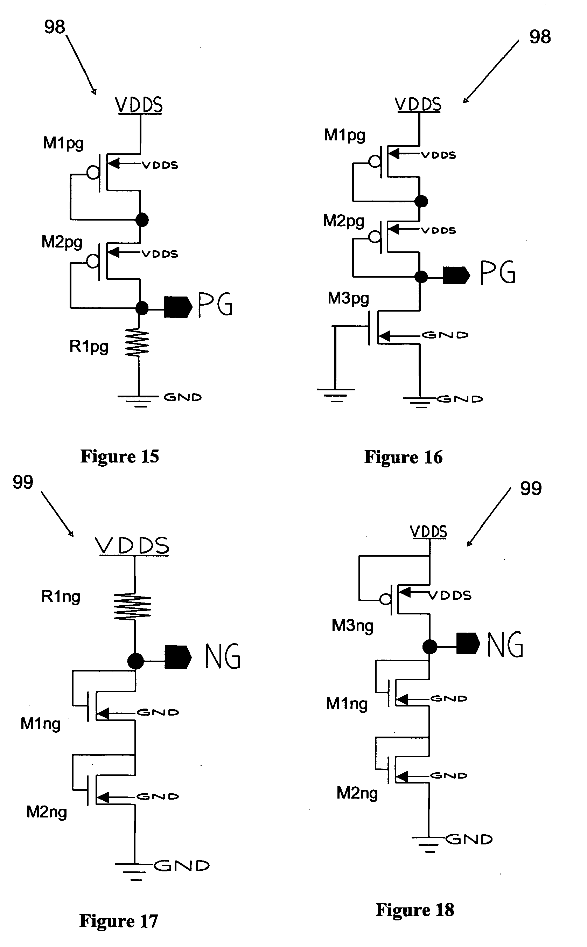

Different embodiments of the first additional PVT detection circuit 98 are shown in figures 15 and 16, while different embodiments of the second additional PVT detection circuit 99 are shown in figures 17 and 18.

As can be seen from these figures, the first additional PVT detection circuit 98 for generating the PG signal are similar to that of the bulk control circuit 91 for generating the NWELL signal, while the second additional PVT detection circuit 99 for generating the NG signal are similar to that of the bulk control circuit 95 for generating the BULK signal.

In particular, figure 15 schematically shows the first additional PVT detection circuit 98 which comprises a first M1pg and a second PMOS transistor M2pg which are connected in diode configuration between the power supply voltage reference VDDS and a control terminal providing the PG signal. Moreover, the first additional PVT detection circuit 98 comprises a resistor R1 inserted between the control terminal and ground GND, in series with the transistors M1pg and M2pg, according to a configuration increasing the insensitivity of the transaction point with respect to process variation. The transistors M1pg and M2pg have bulk terminals connected to the power supply voltage reference VDDS.

As previously seen, to avoid DC consumption, a NMOS transistor M3pg having a gate terminal connected to ground GND can be connected in place of the resistor R1, as shown in figure 16.

In a similar manner, figure 17 schematically shows the second additional PVT detection circuit 99 which comprises a first M1ng and a second NMOS transistor M2ng connected in diode configuration between a control terminal providing the NG signal and ground GND. Moreover, the second additional PVT detection circuit 99 comprises a resistor R1ng inserted between the power supply voltage reference VDDS and the control terminal, in series with the transistors M1ng and M2ng, according to a configuration increasing the insensitivity of the transaction point with respect to process variation. The transistors M1ng and M2ng have bulk terminals connected to ground GND.

To avoid DC consumption, a PMOS transistor M3ng having a gate terminal connected to the power supply voltage reference VDDS can be connected in place of the resistor R1ng, as shown in figure 17.

The bulk control has already been discussed earlier, only the drive control will be discussed and its effect will be explained in detail.

When the signal at the input terminal IN is low, the PMOS transistors P1, P2 and P5 are ON. The PMOS transistor P4 is also ON because its gate terminal is connected to the PG signal that is generated by the first additional PVT detection circuit 98. The voltage value of the PG signal would be (VDDS- |VtM1|-|VtM2|) provided that a current through the PMOS transistors M1pg, M2pg and M3pg is very low. Thus the PMOS transistor P4 of the first bias block 97A is always ON.

The voltage value of the PG signal changes according to the PVT variation. As the signal at the input terminal IN falls, the PMOS input transistors P1 and the second PMOS transistor P5 of the first bias block 97A turn ON and start charging the node VP. The voltage value of the high to low transaction point Vil is determined by the ratio (P1+P5)/P3 along with the NWELL and PG signals. When process gets slow or temperature increases, the driving of the transistors decreases and shifts the level of the high to low transaction point Vil towards ground GND or the high to low transaction point Vil should decrease. However, since the signal PG also decreases and increases the driving of the first PMOS transistor P4 of the first bias block 97A and provides more current through the second PMOS transistor P5 of the first bias block 97A, the effect of temperature or process is counterbalanced. If voltage increases to increase the driving mechanism, the PG signal also increases to decrease the driving of the first PMOS transistor P4 of the first bias block 97A and hence the current is controlled. In this way the effect of PVT variation on current drive is neutralized up to certain extent and hence relatively more stable high to low transaction point Vil is achieved.

When the signal at the input terminal IN is high, the NMOS transistors N1, N2 and N5 are ON. The first NMOS transistor N4 of the second bias block 97B is also ON because its gate terminal is connected to the NG signal that is generated by the second additional PVT detection circuit 99. The voltage value of the NG signal will be (VtM 1+VtM2) provided the current through the NMOS transistors M1, M2 and M3 is very low. Thus the first NMOS transistor N4 of the second bias block 97B is always ON. The voltage value of the NG signal will change according to the PVT variation. As the signal at the input terminal IN rises, the first input NMOS transistor N1 and the second NMOS transistor N5 of the second bias block 97B turn ON and start charging the node VN. The voltage of the low to high transaction point Vih is determined by ratio (N1+N5)/N3 along with the BULK and NG signals. When process gets slow or temperature increases, driving of the transistors decreases thus shifting the level of the low to high transaction point Vih towards the power supply voltage reference VDDS or the low to high transaction point Vih should increase. However, since the NG signal goes up and increases the driving of the first NMOS transistor N4 of the second bias block 97B and sinks more current through the second NMOS transistor N5 of the second bias block 97B, the effect of the temperature or process is counterbalanced. In this way effect of process and temperature on current drive is neutralized up to certain extent and hence relatively more stable low to high transaction point Vih is achieved.

In a general manner, the invention thus relates to an apparatus for providing compensation against temperature, process and supply voltage variation in a MOS circuit comprising:

- a bulk control circuit 91 or 95 connected to N type semiconductor substrate/P type semiconductor substrate of PMOS/NMOS transistors of said MOS circuit; and

- a drive control circuit 98 or 99 connected to PMOS/NMOS bias blocks 97A or 97B.

For a CMOS circuit, the apparatus should comprise:

- a first bulk control circuit 91 connected to N type semiconductor substrate of PMOS transistors of said CMOS circuit;

- a second bulk control circuit 95 connected to P type semiconductor substrate of NMOS transistors of said CMOS circuit;

- a first drive control circuit 98 connected to PMOS bias block 97A; and

- a second drive control circuit 99 connected to NMOS bias block 97B.

From the above explanation it is clear that threshold and current drive control will lead to a very stable compensated circuit 200, which is substantially a Schmitt trigger circuit. Cad results are given in the next section to prove the stability of the compensated circuit according to the present invention.

Simulation Results

Under this section, simulation results have been presented and compared against a standard architecture, which is widely accepted.

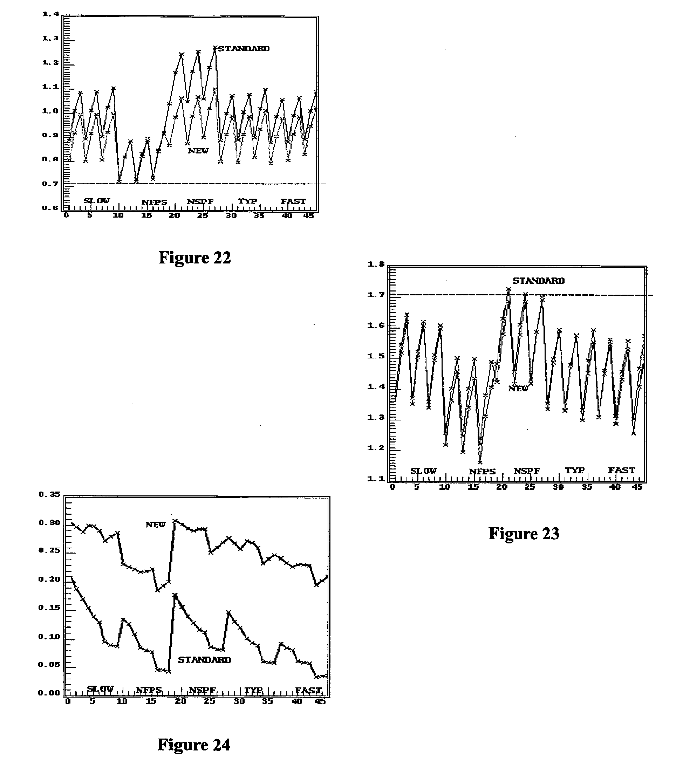

For all the graphs shown in figures 21-28, x-axis represents the PVT variation, where process, voltage and temperature are varying together. There are 45 cases of PVT (all possible combinations of 3-voltages, 3-tempetatures and 5-processes) for which graphs have been plotted. SLOW indicates the process when the PMOS transistors and the NMOS transistors both are slow (3-sigma). NFPS indicates the process when NMOS transistors are fast (6-sigma) and PMOS transistors are slow (6-sigma). NSPF indicates the process when NMOS transistors are slow (6-sigma) and PMOS transistors are fast (6-sigma). TYP indicates the centered process. FAST indicates the process when NMOS and PMOS transistors both are fast (3-sigma).

All the graphs in figure 21 to 26 are plotted for a circuit architecture of the Schmitt type with bulk/nwell control only. All the plots clearly show the remarkable improvement over standard structure across PVTs. For low voltage (1.8 volt) the minimum improvement is 50% for hysteresis.

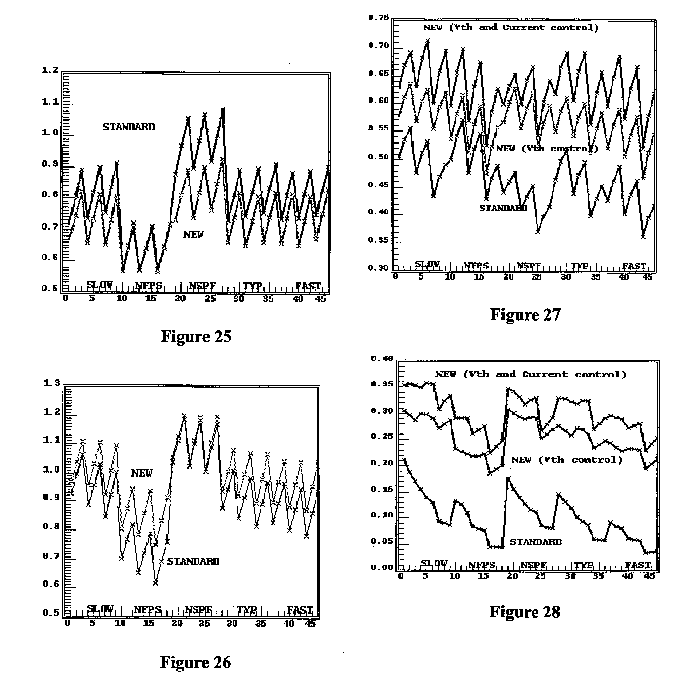

The graphs shown in figure 27 and 28 compare a standard structure with the proposed compensated circuit with Vth (threshold voltage of MOSFETES) control and the proposed compensated circuit with Vth and current control respectively.

**Claims**

1. A method for providing compensation against temperature, process and supply voltage variation in a device comprising MOS transistors comprising the steps of:

   - sensing said process, temperature or supply voltage variation;
   - controlling a bulk bias voltage of said MOS transistors to maintain a constant threshold voltage; and
   - controlling a drive level of said MOS transistors to compensate for the effects of said process, temperature or supply voltage variation.

2. The method as claimed in claim 1 wherein said step of controlling said bulk bias voltage is achieved by increasing a bulk voltage with respect to an input diode below said input diode cut in voltage.

3. The method as claimed in claim 1 wherein said step of controlling said drive level is achieved by switching in additional drive transistors connected to said MOS transistors to increase or decrease a drive current of said MOS transistors.

4. The method as claimed in claim 2 wherein said step of controlling of said bulk bias voltage is done separately for N type semiconductor substrate and P type semiconductor substrate of said MOS transistors.

5. The method as claimed in claim 3 wherein said step of controlling said drive level includes a step of generating separate drive control signals for PMOS and NMOS transistors of said MOS transistors.

6. An apparatus for providing compensation against temperature, process and supply voltage variation in a MOS circuit comprising:

- a bulk control circuit (91, 95) connected to N type semiconductor substrate/P type semiconductor substrate of PMOS/NMOS transistors of said MOS circuit; and
- a drive control circuit (98, 99) connected to PMOS/NMOS bias blocks (97A, 97B).

7. The apparatus as claimed in claim 6 wherein said bulk control circuit (91, 95) includes a plurality of PMOS/NMOS transistors connected to load for providing an output signal for compensating said process, temperature or supply voltage variation.

8. The apparatus as claimed in claim 6 wherein said PMOS/NMOS drive control circuit (98, 99) comprises of plurality of PMOS/NMOS transistors connected in parallel with said PMOS/NMOS transistors of said MOS circuit to increase or decrease the current.

9. An apparatus for providing compensation against temperature, process and supply voltage variation in a CMOS circuit comprising:

- a first bulk control circuit (91) connected to N type semiconductor substrate of PMOS transistors of said CMOS circuit;
- a second bulk control circuit (95) connected to P type semiconductor substrate of NMOS transistors of said CMOS circuit;
- a first drive control circuit (98) connected to PMOS bias block (97A); and
- a second drive control circuit (99) connected to NMOS bias block (97B).

10. The apparatus as claimed in claim 9 wherein said first/second bulk control circuits (91, 95) include a plurality of PMOS/NMOS transistors connected to load for providing an output signal (NWELL, BULK) for compensating said process, temperature or supply voltage variation.

11. The apparatus as claimed in claim 9 wherein said PMOS bias block (97A) comprises of plurality of PMOS transistors connected in parallel with the PMOS transistors of said CMOS circuit to increase or decrease the current.

12. The apparatus as claimed in claim 9 wherein said NMOS bias block (97B) comprises of plurality of NMOS transistors connected in parallel with said NMOS transistors of said CMOS circuit to increase or decrease the current.

13. The apparatus as claimed in claim 6 wherein said MOS circuit includes a Schmitt trigger.

14. The apparatus as claimed in claim 6 wherein said MOS circuit includes an input buffer.

15. A compensated circuit (200) against temperature, process and supply voltage variation of the type comprising at least:

- a plurality of input PMOS transistors (P1, P2) and NMOS transistors (N1, N2), in series to each other and connected between a first and a second voltage references (VDDS, GND) and coupled by their respective gate electrodes to an input terminal (IN) of said compensated circuit (200);
- a first control PMOS transistor (P3) and a second control NMOS transistor (N3) which realise a feedback structure and having respective gate terminals connected together at an internal node (N) of the compensated circuit (200); and
- a first and a second output transistors (M 1, M2) which realise an output inverter connected to an output terminal (OUT) of said compensated circuit (200),

wherein it further comprises at least a first and a second bulk control circuits (91, 95) connected to the bulk terminals of said PMOS transistors (P1, P2, P3) and of said NMOS transistors (N1, N2, N3), respectively.

16. The compensated circuit (200) as claimed in claim 15 wherein said first and second bulk control circuits (91, 95) are able to detect process variation and generate respective first and second control signals (NWELL, BULK).

17. The compensated circuit (200) as claimed in claim 16 wherein said first bulk control circuit (91) comprises:

- a PMOS transistor (M1p) having same channel length as said PMOS transistors (P1, P2, P3), being connected in diode configuration between said first voltage reference (VDDS) and a first control terminal providing the said first control signal (NWELL) and having a bulk terminal connected to said first voltage reference (VDDS); and
- a resistor element (R1) inserted between said first control terminal and said second voltage reference (GND), in series with said PMOS transistor (M1p) in order to set the bias current through said PMOS transistor (M1p).

18. The compensated circuit (200) as claimed in claim 17 wherein said resistor element (R1) comprises a NMOS transistor (M2p) having a gate terminal connected to said second voltage reference (GND).

19. The compensated circuit (200) as claimed in claim 17 wherein said first bulk control circuit (91) further comprises an additional PMOS transistor (M3p) being diode connected in series with said PMOS transistor (M1p).

20. The compensated circuit (200) as claimed in claim 16 wherein said second bulk control circuit (95) comprises:

- a NMOS transistor (M1n) which is connected in diode configuration between a second control terminal providing said second control signal (BULK) and said second voltage reference (GND) and having a bulk terminal connected to said second voltage reference (GND); and
- a resistor element (R2) inserted between said first voltage reference (VDDS) and said second control terminal, in series with said NMOS transistor (M1n).

21. The compensated circuit (200) as claimed in claim 20 wherein said resistor element (R2) comprises a PMOS transistor (M2n) having a gate terminal connected to said first voltage reference (VDDS).

22. The compensated circuit (200) as claimed in claim 20 wherein said second bulk control circuit (95) further comprises an additional NMOS transistor (M3n) being diode connected in series with said NMOS transistor (M 1 n).

23. The compensated circuit (200) as claimed in claim 15 wherein it further comprises first and second bias blocks (97A, 97B), suitably connected to respective first and second additional PVT detection circuits (98, 99) to control the current drive while maintaining the threshold voltage.

24. The compensated circuit (200) as claimed in claim 23 wherein said first bias block (97A) comprises a series of first and second PMOS bias transistors (P4, P5) which are added in parallel with said first input PMOS transistor (P1) to increase or decrease the current according to PVT variation, said bias PMOS transistors (P4, P5) being connected, in series to each other, between said first voltage reference (VDDS) and an interconnection node between said first and second input PMOS transistors (P1, P2) and have respective bulk terminals connected to said first voltage reference (VDDS), said second bias PMOS transistor (P5) having a gate terminal connected to said input terminal (IN) of said compensated circuit (200), and said first bias PMOS transistor (P4) having a gate terminal connected to said first additional PVT detection circuit (98) and receive a first control signal (PG) therefrom.

25. The compensated circuit (200) as claimed in claim 23 wherein said second bias block (97B) comprises a series of first and second NMOS bias transistors (N4, N5) which are added in parallel with said first input NMOS transistor (N1) to increase or decrease the current according to PVT variation, said bias NMOS transistors (N4, N5) being connected, in series to each other, between an interconnection node between said first and second input NMOS transistors (N1, N2) and said second voltage reference (GND) and having respective bulk terminals connected to said second voltage reference (GND), said second bias NMOS transistor (N5) having a gate terminal connected to said input terminal (IN) of said compensated circuit 200, and the first bias NMOS transistor (N4) having a gate terminal connected to said second additional PVT detection circuit (99) and receiving a second control signal (NG) therefrom.

26. The compensated circuit (200) as claimed in claim 23 wherein said first additional PVT detection circuit (98) comprises first and second PMOS transistors (Mlpg, M2pg) which are connected in diode configuration between said first voltage reference (VDDS) and a control terminal providing said first control signal (PG) and a resistor element (R1pg) inserted between said control terminal and said second volgate reference (GND), in series with said PMOS transistors (M1pg, M2pg) having in turn bulk terminals connected to said first voltage reference (VDDS).

27. The compensated circuit (200) as claimed in claim 26 wherein said resistor element (R1pg) comprises a NMOS transistor (M3pg) having a gate terminal connected to said second voltage reference (GND).

28. The compensated circuit (200) as claimed in claim 23 wherein said second additional PVT detection circuit (99) comprises first and second NMOS transistors (M1ng, M2ng) connected in diode configuration between a control terminal providing said second control signal (NG) and said second voltage reference (GND) and a resistor element (R1ng) inserted between said first voltage reference (VDDS) and said control terminal, in series with said first and second NMOS transistors (Mlng, M2ng) having in turn bulk terminals connected to said second voltage reference (GND).

29. The compensated circuit (200) as claimed in claim 26 wherein said resistor element (R1ng) comprises a PMOS transistor (M3ng) having a gate terminal connected to said first voltage reference (VDDS).

**Figure 1**

PRIOR ART

**Figure 2**

PRIOR ART

14

**Figure 3**

PRIOR ART

**Figure 4**

Figure 5

**Figure 6**

**Figure 7**

**Figure 8**

**Figure 9**

Figure 10

Figure 11

Figure 12

Figure 13

**Figure 14**

**Figure 15**

**Figure 16**

**Figure 17**

**Figure 18**

**Figure 19**

**Figure 20**

**Figure 21**

Figure 22

Figure 23

Figure 24

Figure 25

Figure 27

Figure 26

Figure 28